# EUROPÄISCHE PATENTANMELDUNG

(11) **EP 1 635 464 A2**
(43) Veröffentlichungstag der Anmeldung: **15.03.2006**
(21) Anmeldenummer: 05019401.8
(22) Anmeldetag: 07.09.2005
(51) Int. Cl.: H03K 17/94

(54) **Siebensegmentanzeige**

(30) Priorität: 09.09.2004 DE 102004043571
(71) Anmelder: Diehl AKO Stiftung & Co. KG, 88239 Wangen (DE)
(72) Erfinder: Wiekenberg, Günther, 90513 Zirndorf (DE)
(74) Vertreter: Diehl Patentabteilung

(57) **Zusammenfassung**

Es wird eine Segmentanzeige (10) für eine Bedien- und Anzeigeeinrichtung eines elektronischen Haushaltsgeräts vorgeschlagen, mit einem Gehäuse (12), mehreren in dem Gehäuse angeordneten Leuchtsegmenten (14a - 14g) zur Darstellung von Informationen, und einer Steuerschaltung zum Ansteuern der Leuchtsegmente entsprechend den darzustellenden Informationen. Erfindungsgemäß ist diese Segmentanzeige mit einem Tastschalter kombiniert, wobei das Gehäuse (12) der Segmentanzeige (10) eine erste Gehäuseöffnung (16) und eine zweite Gehäuseöffnung (20) aufweist, und in der ersten Gehäuseöffnung (16) ein Sendeelement (18) zum Aussenden elektromagnetischer Strahlung angeordnet ist und in der zweiten Gehäuseöffnung (20) ein Empfangselement (22) zum Empfangen elektromagnetischer Strahlung angeordnet ist.

## Beschreibung

Die vorliegende Erfindung betrifft eine Segmentanzeige nach dem Oberbegriff des Anspruchs 1, und insbesondere eine solche Segmentanzeige zur Verwendung in einer Bedien- und Anzeigeeinrichtung eines elektronischen Haushaltsgeräts.

Bedien- und Anzeigeeinrichtung für elektronische Haushaltsgeräte, wie beispielsweise Kochherde, Mikrowellenherde, Kochfelder, Waschmaschinen, Wäschetrockner, Spülmaschinen und dergleichen, sind häufig mit Segmentanzeigen, insbesondere Siebensegmentanzeigen zur digitalen Anzeige von Kochstufen, Kochzeit, Uhrzeit und dergleichen versehen.

Aus der EP-A-1 030 536 ist ferner eine Siebensegmentanzeige mit einem integrierten Tastschalter für ein elektronisches Haushaltsgerät bekannt. Die Siebensegmentanzeige weist ein Gehäuse, sieben Leuchtsegmente und eine Steuerschaltung zum Ansteuern der Leuchtsegmente auf. Auf der dem Benutzer zugewandten Oberfläche des Gehäuses dieser Siebensegmentanzeige ist weiter ein kapazitives Sensorelement angeordnet, welches entsprechend den Leuchtsegmenten der Siebensegmentanzeige ausgeschnitten ist. Durch Berühren der Siebensegmentanzeige, d.h. genauer des kapazitiven Sensorelements kann so durch den Benutzer der integrierte kapazitive Tastschalter betätigt werden, um zum Beispiel ein der Siebensegmentanzeige zugeordnetes Kochfeld ein- und auszuschalten.

Der Erfindung liegt die Aufgabe zugrunde, eine weitere Segmentanzeige mit einem integrierten Tastschalter vorzusehen.

Diese Aufgabe wird gelöst durch eine Segmentanzeige mit den Merkmalen des Anspruchs 1. Vorteilhafte Ausgestaltungen und Weiterbildungen der Erfindung sind Gegenstand der abhängigen Ansprüche.

Die Segmentanzeige weist ein Gehäuse, mehrere in dem Gehäuse angeordneten Leuchtsegmente zur Darstellung von Informationen und eine Steuerschaltung zum Ansteuern der Leuchtsegmente entsprechend den darzustellenden Informationen auf.

Gemäß der Erfindung ist das Gehäuse der Segmentanzeige mit einer ersten Gehäuseöffnung und einer zweiten Gehäuseöffnung versehen, und in der ersten Gehäuseöffnung ist ein Sendeelement zum Aussenden elektromagnetischer Strahlung angeordnet und in der zweiten Gehäuseöffnung ist ein Empfangselement zum Empfangen elektromagnetischer Strahlung angeordnet.

Die so aufgebaute Segmentanzeige hat platzsparend und in einfacher Weise einen berührungsempfindlichen Tastschalter integriert. Das Gehäuse der Segmentanzeige bildet dabei gleichzeitig das Gehäuse für die Sensorelemente (Sendeelement, Empfangselement) des berührungsempfindlichen Tastschalters. Eine Beeinflussung zwischen der Anzeige und den Sensorelementen besteht nicht, da die verwendeten Wellenlängen weit auseinander liegen können.

Eine solche Segmentanzeige ist vorteilhafterweise in einer Bedien- und Anzeigeeinrichtung für ein elektronisches Haushaltsgerät, wie beispielsweise Kochherde, Mikrowellenherde, Kochfelder, Waschmaschinen, Wäschetrockner, Spülmaschinen und dergleichen, anwendbar. Zum Beispiel kann durch Berühren der einer Kochstelle zugeordneten Anzeige diese Kochstelle ausgewählt bzw. ein- und ausgeschaltet werden.

Die elektromagnetische Strahlung ist zum Beispiel Infrarot-Strahlung, d.h. der in die Segmentanzeige integrierte berührungsempfindliche Tastschalter ist ein Infrarot-Tastschalter.

Zur Erzielung einer noch platzsparenderen Bauweise sind die erste und die zweite Gehäuseöffnung bevorzugt jeweils zwischen den Leuchtsegmenten angeordnet.

In einer bevorzugten Ausführungsform der Erfindung ist die Segmentanzeige eine Siebensegmentanzeige mit sieben in der Form einer "8" angeordneten Leuchtsegmenten. Hierbei ist die eine der ersten und der zweiten Gehäuseöffnung zwischen den oberen vier Leuchtsegmenten angeordnet und die andere der ersten und der zweiten Gehäuseöffnung ist zwischen den unteren vier Leuchtsegmenten angeordnet, wobei das mittlere horizontale Leuchtsegment der Siebensegmentanzeige einen Trennsteg zwischen dem Sendeelement und dem Empfangselement bildet.

Das Empfangselement kann ferner mit einem Tageslichtfilter versehen sein, um die Beeinflussung des Empfangselements durch die Leuchtsegmentanzeige weiter zu unterdrücken.

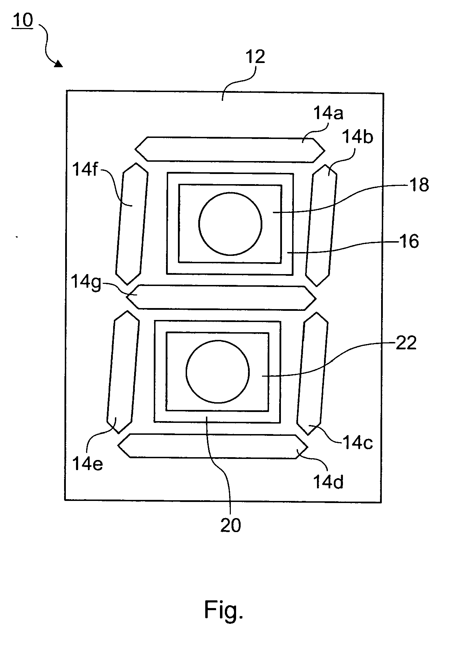

Obige sowie weitere Merkmale und Vorteile der Erfindung werden aus der nachfolgenden Beschreibung eines bevorzugten, nicht-einschränkenden Ausführungsbeispiels unter Bezugnahme auf die beiliegenden Zeichnungen besser verständlich. Darin zeigt die einzige Figur eine schematische Draufsicht einer Segmentanzeige gemäß der vorliegenden Erfindung.

In der Figur ist eine Siebensegmentanzeige 10 mit integriertem Infrarot-Tastschalter als bevorzugtes Ausführungsbeispiel einer Segmentanzeige gemäß der vorliegenden Erfindung zur Verwendung in einem elektronischen Haushaltsgerät wie Kochherd, Mikrowellenherd, Kochfeld, Waschmaschine, Wäschetrockner, Spülmaschine und dergleichen dargestellt. Eine solche Siebensegmentanzeige 10 ist vorteilhafterweise Bestandteil einer Bedien- und Anzeigeeinrichtung des elektronischen Haushaltsgeräts, und durch Betätigen des integrierten Tastschalters kann zum Beispiel ein der Segmentanzeige zugeordnetes Kochfeld bedient (zum Beispiel ein- und ausgeschaltet) werden.

Die Siebensegmentanzeige 10 weist in einem Gehäuse 12 sieben Leuchtsegmente 14a bis 14g auf, die bekannterweise in der Form einer "8" angeordnet sind, um eine digitale Anzeige der Ziffern "0" bis "9" zu ermöglichen. Die sieben Leuchtsegmente 14a - 14g werden durch eine Steuerschaltung (nicht dargestellt) entsprechend den anzuzeigenden Informationen angesteuert. Da der Aufbau und die Funktionsweise einer derartigen Siebensegmentanzeige dem Fachmann hinlänglich bekannt sind und sie nicht Gegenstand der vorliegenden Erfindung sind, wird auf eine nähere Beschreibung davon verzichtet.

In dem Zwischenraum zwischen den oberen vier Leuchtsegmenten 14a, 14b, 14f und 14g ist eine erste Gehäuseöffnung 16 vorgesehen, in der ein Sendeelement 18 zum Aussenden elektromagnetischer Strahlung, bevorzugt Infrarot-Strahlung angeordnet ist. Eine zweite Gehäuseöffnung 20 zur Aufnahme eines Empfangselements 22 zum Empfangen einer elektromagnetischen Strahlung der gleichen Wellenlänge wie die von dem Sendeelement ausgesendete Strahlung ist in dem Zwischenraum zwischen den unteren vier Leuchtsegmenten 14a, 14d, 14e und 14g der Siebensegmentanzeige 10 vorgesehen. Das mittlere horizontale Leuchtsegment 14g der Siebensegmentanzeige 10 übernimmt dabei gleichzeitig die Funktion eines Trennsteges zwischen dem Sendeelement 18 und dem Empfangselement 22, um ein Querlicht / Streulicht zwischen den beiden Sensorelementen 18, 22 zu vermeiden.

Das Gehäuse 12 der Siebensegmentanzeige 10 bildet somit gleichzeitig das Gehäuse für die Sensorelemente 18 und 22. Die beiden Sensorelemente 18 und 22 werden in üblicher und dem Fachmann hinlänglich bekannter Weise angesteuert und ausgewertet, sodass auf eine detaillierte Beschreibung davon im Rahmen dieser Erfindung verzichtet werden kann.

Eine Beeinflussung der Sensorelemente 18 und 22 durch das Licht der Leuchtsegmente 14a - 14g wird aufgrund des groß wählbaren Wellenlängenunterschieds zwischen den beiden verwendeten Strahlungsarten vermieden. Zusätzlich kann das Empfangselement 22 mit einem Tageslichtfilter (nicht dargestellt) versehen sein. Ferner ist es möglich den Multiplex der Ansteuerung der Sensorelemente 18, 22 zwischen den Multiplex der Ansteuerung der Leuchtsegmente 14a - 14g zu legen.

Während die Erfindung oben unter Bezugnahme auf die beiliegende Zeichnung vollständig beschrieben worden ist, ist es für den Fachmann selbstverständlich, dass zahlreiche Änderungen und Modifikationen daran vorgenommen werden können, ohne den Schutzumfang der Erfindung zu verlassen, wie er durch die anhängenden Ansprüche definiert ist.

Zum Beispiel kann auch eine andere elektromagnetische Strahlung als die Infrarot-Strahlung für die Sensorelemente 18, 20 des berührungsempfindlichen Tastschalters verwendet werden, sofern sie einen gewissen Wellenlängenabstand zu der Wellenlänge der Leuchtsegmente 14a - 14g der Segmentanzeige 10 aufweisen, sodass die Sensorelemente 18, 20 nicht durch die Anzeige beeinflusst werden.

Außerdem ist die Segmentanzeige weder auf die Anzahl noch auf die Anordnung der Leuchtsegmente 14a - 14g des oben beschriebenen Ausführungsbeispiels beschränkt. Je nach Art der mit der Segmentanzeige darzustellenden Informationen wird eine Segmentanzeige mit weniger oder mehr als sieben Leuchtsegmenten ausgewählt, wobei die Leuchtsegmente entsprechend den mit ihnen darzustellenden Zeichen angeordnet sind.

In dem oben erläuterten Ausführungsbeispiel sind die beiden Sensorelemente 18 und 22 zwischen den Leuchtsegmenten 14a - 14g der Segmentanzeige 10 angeordnet. Grundsätzlich ist es aber ebenfalls möglich, eines oder beide der Sensorelemente 18 und 22 außerhalb der Leuchtsegmentgruppe, aber noch innerhalb des Gehäuses 12 der Segmentanzeige 10 anzuordnen.

Die Segmentanzeige der Erfindung kann auch aus zwei oder mehr z.B. Siebensegmentanzeigen aufgebaut sein, die nebeneinander in einem Gehäuse 12 angeordnet sind. In diesem Fall ist es möglich, auch eine entsprechende Anzahl von berührungsempfindlichen Tastschaltern in die Segmentanzeige zu integrieren und den verschiedenen Tastschaltern auch unterschiedliche Bedienfunktionen (zum Beispiel "größer" und "kleiner", usw.) zuzuordnen. Beispielsweise ist eine Segmentanzeige mit einer zweistelligen digitalen Anzeige der Kochstufe denkbar, die mit einem ersten Tastschalter zum Verkleinern der Kochstufe des zugehörigen Kochfeldes und einem zweiten Tastschalter zum Erhöhen der Kochstufe kombiniert ist.

### BEZUGSZIFFERNLISTE

- 10: Siebensegmentanzeige
- 12: Gehäuse
- 14a - 14g: Leuchtsegmente
- 16: Gehäuseöffnung
- 18: Sendeelement
- 20: Gehäuseöffnung
- 22: Empfangselement

## Patentansprüche

1. Segmentanzeige (10), mit einem Gehäuse (12), mehreren in dem Gehäuse angeordneten Leuchtsegmenten (14a - 14g) zur Darstellung von Informationen, und einer Steuerschaltung zum Ansteuern der Leuchtsegmente entsprechend den darzustellenden Informationen,
**dadurch gekennzeichnet,**
**dass** das Gehäuse (12) eine erste Gehäuseöffnung (16) und eine zweite Gehäuseöffnung (20) aufweist, und
in der ersten Gehäuseöffnung (16) ein Sendeelement (18) zum Aussenden elektromagnetischer Strahlung angeordnet ist und in der zweiten Gehäuseöffnung (20) ein Empfangselement (22) zum Empfangen elektromagnetischer Strahlung angeordnet ist.

2. Segmentanzeige nach Anspruch 1,
**dadurch gekennzeichnet,**
**dass** die elektromagnetische Strahlung Infrarot-Strahlung ist.

3. Segmentanzeige nach Anspruch 1 oder 2,
**dadurch gekennzeichnet,**
**dass** die erste und die zweite Gehäuseöffnung (16, 20) jeweils zwischen den Leuchtsegmenten (14a - 14g) angeordnet sind.

4. Segmentanzeige nach einem der vorhergehenden Ansprüche 3,
**dadurch gekennzeichnet,**
**dass** die Segmentanzeige (10) eine Siebensegmentanzeige mit sieben in der Form einer "8" angeordneten Leuchtsegmenten (14a - 14g) ist.

5. Segmentanzeige nach Anspruch 4,
**dadurch gekennzeichnet,**
**dass** die eine der ersten und der zweiten Gehäuseöffnung (16, 20) zwischen den oberen vier Leuchtsegmenten (14a, 14b, 14f, 14g) angeordnet ist und die andere der ersten und der zweiten Gehäuseöffnung (16, 20) zwischen den unteren vier Leuchtsegmenten (14c, 14d, 14e, 14g) angeordnet ist, und
**dass** das mittlere horizontale Leuchtsegment (14g) der Siebensegmentanzeige (10) einen Trennsteg zwischen dem Sendeelement (18) und dem Empfangselement (22) bildet.

6. Segmentanzeige nach einem der vorhergehenden Ansprüche,
**dadurch gekennzeichnet,**
**dass** das Empfangselement (22) mit einem Tageslichtfilter versehen ist.

7. Bedien- und Anzeigeeinrichtung für ein elektronisches Haushaltsgerät mit wenigstens einer Segmentanzeige nach einem der Ansprüche 1 bis 6.
